# EUROPEAN PATENT APPLICATION

(11) **EP 4 650 808 A1**
(43) Date of publication of application: **19.11.2025**
(21) Application number: 24179502.0
(22) Date of filing: 03.06.2024
(51) Int. Cl.: G01R 33/3815

(54) **MAGNET ASSEMBLY FOR USE IN A MAGNETIC RESONANCE EXAMINATION SYSTEM**

(30) Priority: 15.05.2024 US 202463647754 P
(71) Applicant: Koninklijke Philips N.V., 5656 AG Eindhoven (NL)
(72) Inventor: FORTHMANN, Peter, Eindhoven (NL); LIPS, Oliver, Eindhoven (NL); VERNICKEL, Peter, 5656AG Eindhoven (NL); HILDERBRAND, Joshua Kent, Eindhoven (NL)
(74) Representative: Philips Intellectual Property & Standards

(57) **Abstract**

The invention relates to a magnet assembly (2) for use in a magnetic resonance examination system (1), comprising a superconducting magnet coil (3), a gradient coil system (4) with a plurality of gradient coils (5) for generating gradient fields, and a thermal radiation screen (6) which at least partly encloses the superconducting magnet coil (3), wherein the thermal radiation screen (6) is designed in such a way that its transmission rate for thermal radiation within a wavelength range from 780 nm to 2.5 µm is at least by a factor of 10 less than the transmission rate of radiation of the gradient fields. In this way, an enhanced magnet assembly (2) for use in a magnetic resonance examination system (1) is provided.

## Description

### FIELD OF THE INVENTION

The invention relates to the field of magnetic resonance (MR) examination technology, with a particular focus on a magnet assembly with a superconducting magnet for use in a magnetic resonance examination system.

### BACKGROUND OF THE INVENTION

Magnetic resonance examination technology and especially magnetic resonance imaging (MRI) is a sophisticated technique used in the medical field, MRI being able to produce high-resolution images of the inside of the human body. This non-invasive method is particularly useful for imaging soft tissues, making it an invaluable tool in diagnosing various conditions. The core technology enabling MRI is the use of strong magnetic fields, radio waves and gradient fields.

In MRI systems, the MRI magnet is arguably the most critical component. It is responsible for creating a stable and homogeneous magnetic field within which the human body (or the object of study) is placed. The most common type of magnet used in conventional MRI systems is the superconducting magnet, which requires cooling to cryogenic temperatures to function without electrical resistance, thereby maintaining a strong magnetic field without continuous power input.

One of the design elements of these MRI magnets is the inclusion of a solid radiation shield. This shield serves a dual purpose. The primary function of the solid radiation shield is to protect the superconducting magnet, which operates at cryogenic temperatures, from heat radiation originating at room temperature. Heat radiation can increase the temperature of the superconducting magnet, potentially causing it to lose its superconducting properties and thus its ability to maintain a magnetic field without power input. By intercepting this heat radiation, the shield helps maintaining the necessary low temperatures for superconductivity to persist. Besides this interception of room temperature heat radiation, a secondary benefit of the solid radiation shield is its ability to protect the cold mass (the part of the magnet kept at cryogenic temperatures) from stray fields generated by the gradient coils. Gradient coils are used in MRI systems to spatially vary the magnetic field, which is necessary for encoding spatial information into the MRI signal. However, these coils can produce stray magnetic fields that, if not properly managed, could induce eddy currents in metallic structures within the cold mass and the superconducting materials themselves. Eddy currents are circular currents induced within conductors by a changing magnetic field in the conductor, according to Faraday's law of electromagnetic induction. These currents can generate heat, which is undesirable in the cold mass due to the potential to increase its temperature and affect the superconductivity of the magnet.

The design and implementation of a solid radiation shield in MRI systems exemplify the intricate balance required in managing thermal and electromagnetic interactions within these sophisticated devices. By minimizing heat influx and protecting against unwanted electromagnetic interactions, the solid radiation shield plays a crucial role in ensuring the efficiency, stability, and longevity of the MRI system's core magnetic components. This, in turn, enables the production of high-quality images essential for accurate diagnosis and research.

Gradient coils in MRI systems are used to spatially encode the positions of the hydrogen atoms in the body by varying the magnetic field linearly across the imaging volume. This variation allows the MRI system to create images that can be reconstructed to show detailed anatomical structures. The operation of gradient coils involves rapid switching of the magnetic field gradients on and off, which is necessary for slice selection, phase encoding, and frequency encoding.

The frequencies at which gradient coils operate are typically in the range of a few kilohertz (kHz) to several tens of kHz. The specific frequency depends on the gradient switching speed (the rate at which the gradients can be turned on and off, which affects the imaging speed and resolution) and the design of the MRI system. The rapid switching of these gradients is what produces the characteristic knocking or tapping sounds heard during an MRI scan.

The frequency of the gradient fields themselves (related to the Larmor frequency of the nuclei being imaged) is not directly a characteristic of the gradient coils but rather a function of the main magnetic field and the type of nuclei being imaged (usually hydrogen protons in clinical MRI). The gradients modify the effective magnetic field experienced by the protons, thereby encoding spatial information into the signal based on their precessional frequencies, but this is not typically described in terms of the operating frequency of the gradient coils themselves.

Gradient coils usually have a dedicated active shielding layer that reins in the stray field generated by the main coils as best as possible. This, however, comes at the cost of efficiency and space. In cases in which the cold mass is made more tolerant with respect to these eddy currents, it would be possible to reduce the gradient coil shielding effort.

As described in US 2006/0266053 A1, MRI systems are critical for medical imaging, providing detailed images of soft tissues through the excitation and detection of magnetic resonance signals from selected dipoles in the subject. This process necessitates a strong, uniform magnetic field, typically generated by superconducting magnet coils cooled to cryogenic temperatures using cryogens like liquid helium. However, these cryogens are scarce and expensive, highlighting the need for efficient thermal isolation of the coils to reduce cooling requirements. Thermal shields surrounding the superconducting coils, often made from aluminum alloys, serve this purpose. Aluminum is chosen for its low density, light weight, good strength, and thermal conductivity. Yet, its high electrical conductivity may lead to mechanical stresses when the magnet quenches and unwanted field contributions can degrade MRI image quality. Field instability comes in two forms: gradient and vibration-induced. The former is due to magnetic fields during gradient pulses that may cause image artifacts, while the latter results from vibrations (from cooling engines, environmental factors, and gradient pulses), generating eddy currents that lower image quality. These issues make it challenging and costly to maintain image quality in MRI systems. In this respect, US 2006/0266053 A1 proposes a thermal shield for a superconducting magnet that includes a shield body having an annular shape. The shield body includes a material having a thermal conductivity greater than about 1000 W/m·K at about 70 K.

### SUMMARY OF THE INVENTION

It is an object of the invention to provide an enhanced magnet assembly for use in a magnetic resonance examination system.

According to the invention, this object is addressed by the subject matter of the independent claims. Embodiments of the invention are described in the dependent claims.

Therefore, according to the invention, a magnet assembly for use in a magnetic resonance examination system is provided, comprising a superconducting magnet coil, a gradient coil system with a plurality of gradient coils for generating gradient fields, and a thermal radiation screen which at least partly encloses the superconducting magnet coil, wherein the thermal radiation screen is designed in such a way that its transmission rate for thermal radiation within a wavelength range from 780 nm to 2.5 µm, with other words optical heat radiation within the wavelength range from 780 nm to 2.5 µm, is at least by a factor of 10 less than the transmission rate of radiation of the gradient fields.

Hence, according to the invention, a design for a radiation screen is proposed that is transparent to magnetic fields yet opaque to infrared radiation. This means that it will not generate eddy currents while effectively blocking heat radiation. Hence, aspects of the invention relate to the insulation coating that prevents eddy currents to form, because there are no closed conducting paths.

In general, the thermal radiation screen may be manufactured from different materials and with different structures and designs. According to an aspect of the invention, the thermal radiation screen comprises a textile structure with electrically conducting fibers which are each surrounded by an insulating coating. According to a further aspect of the invention, the insulatingly coated electrically conducting fibers of the textile are woven, braided or knitted to each other or are arranged parallel to each other. Therefore, a cloth-like structure is proposed for the radiation screen.

The electrically conducting fibers of the textile structure may be made from different materials. According to an aspect of the invention, the electrically conducting fibers of the textile structure are metal filaments. Further, according to an aspect of the invention, the electrically conducting fibers of the textile structure are Cu and/or Al filaments.

According to an aspect of the invention, the textile structure may be comprised of magnet wire, also known as enameled wire, which is a type of wire coated with a very thin layer of insulation. It is typically made of copper or aluminum, with copper being the most common due to its excellent electrical conductivity. The insulation layer is usually made from polymers like polyurethane, polyester, or polyimide, and it is much thinner than the traditional insulation found on electrical wires. This thin insulation allows for a compact coil winding, maximizing the number of windings that can be fit into a given space and thus improving the efficiency of the electromagnetic device it is used in. Magnet wire is known from the manufacturing of electrical and electromagnetic components such as transformers, inductors, motors, speakers, hard disk head actuators, electromagnets, and various types of coils. The thin insulation layer enables the wire to be wound tightly, creating dense coils that enhance the magnetic field strength produced by the current flowing through the wire. It is also well known to make copper braids from such enameled wires.

According to another aspect of the invention, the thermal radiation screen comprises a supporting structure to hold the textile structure in place. According to an aspect of the invention, the supporting structure may be a backer structure which is separate from the textile structure but may also be integral with the textile structure. According to an aspect of the invention, the supporting structure has a birdcage-like shape or a cylindrical shape. Further, it is an aspect of the invention that the supporting structure is made from an epoxy resin-glass fabric composite material.

According to an aspect of the invention, the textile structure is cast in resin. Resin may act as a supporting structure which is integral with the textile structure.

It is also an aspect of the invention, that the thermal radiation screen comprises a metallic covering for reducing emissivity. The metallic covering may comprise an aluminum tape and/or an aluminized polyester sheet. In this respect, according to an aspect of the invention, the polyester sheet is made from biaxially oriented polyethylene terephthalate (BoPET), also known under the trade name Mylar^{®}.

According to a further aspect of the invention, the thermal radiation screen comprises heat conducting terminals for connecting to a cold head of a cryostat for the superconducting magnet coil.

The invention also relates to a magnetic resonance examination system with a magnet assembly as described above and a method of use of a magnet assembly according as described above for a magnetic resonance examination system.

### BRIEF DESCRIPTION OF THE DRAWINGS

These and other aspects of the invention will be apparent from and elucidated with reference to the embodiments described hereinafter. Such an embodiment does not necessarily represent the full scope of the invention.

In the drawings:
Fig. 1 schematically depicts a magnet assembly according to an embodiment of the invention;
Fig. 2 schematically depicts a magnetic resonance examination system with the magnet assembly from Fig. 1;
Fig. 3 schematically depicts a textile structure with a supporting structure of the magnet assembly from Fig. 1;
Fig. 4 schematically depicts an electrically conducting fiber with an insulating coating of the magnet assembly from Fig. 1 in a cross-sectional view;
Fig. 5 schematically depicts a woven textile structure of the magnet assembly from Fig. 1;
Fig. 6 schematically depicts a thermal radiation screen of the magnet assembly from Fig. 1 with a metallic covering.

### DETAILED DESCRIPTION OF EMBODIMENTS

For the purpose of promoting and understanding the principles of the present disclosure, reference will now be made to the embodiments illustrated in the drawings, and specific language will be used to describe the same. It is nevertheless understood that no limitation to the scope of the disclosure is intended. Any alteration and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a method, in a corresponding manner.

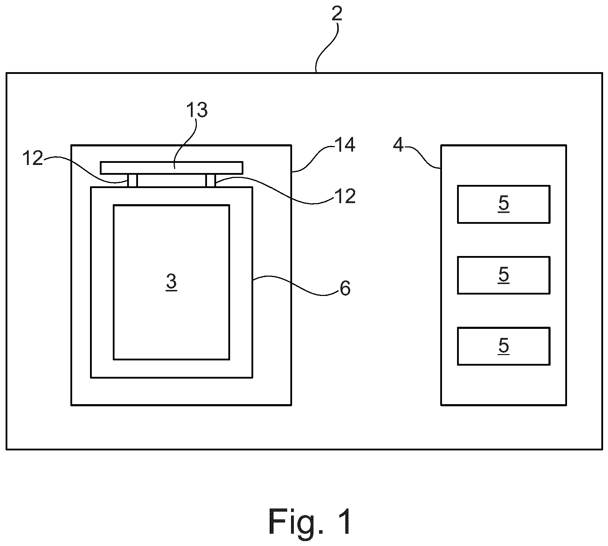

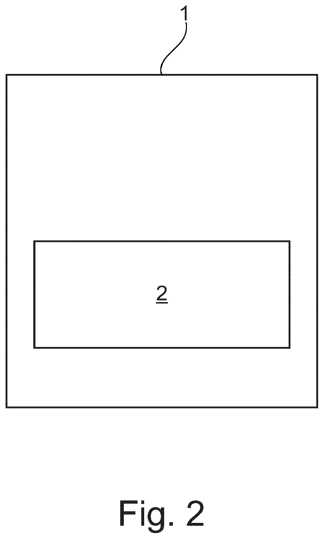

In Fig. 1, schematically a magnet assembly 2 for use in a magnetic resonance examination system 1 is shown, the magnetic resonance examination system 1 being schematically depicted in Fig. 2. The magnet assembly 2 comprises a superconducting magnet coil 3, a gradient coil system 4 with a plurality of gradient coils 5 for generating gradient fields, and a thermal radiation screen 6, which encloses the superconducting magnet coil 3. The thermal radiation screen 6 is designed such that its transmission rate for optical heat radiation within a wavelength range from 780 nm to 2.5 µm is at least by a factor of 10 less than the transmission rate of radiation of the gradient fields. This means that a radiation screen 6 is provided, which is essentially transparent to magnetic fields but opaque to infrared radiation. Therefore, the radiation screen 6 in general does not generate eddy currents but effectively blocks heat radiation.

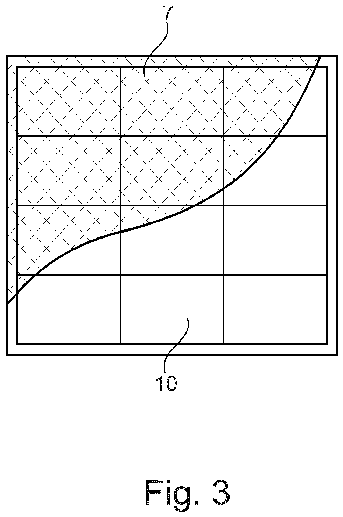

As schematically depicted in Fig. 3, the thermal radiation screen 6 comprises a textile structure 7 which is held in place by a rigid supporting structure 10. Here, the supporting structure 10 is a backer structure which is separate from the textile structure 7. The supporting structure 10 may be made from an epoxy resin-glass fabric composite material. In the alternative, the supporting structure 10 may be integral with the textile structure 7, e. g. the textile structure 7 may be cast in resin.

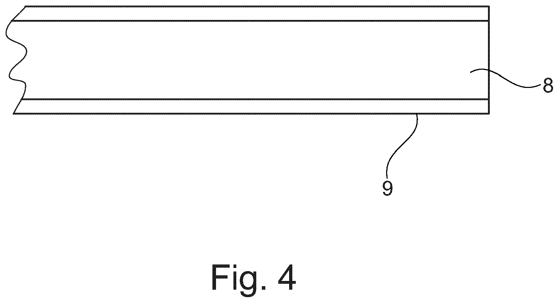

The textile structure 7 itself comprises electrically conducting fibers 8 which are each surrounded by an insulating coating 9 as schematically depicted in Fig. 4. According to the embodiment of the invention described here, the electrically conducting fibers 8 of the textile structure 7 are metal filaments made from Cu and/or Al.

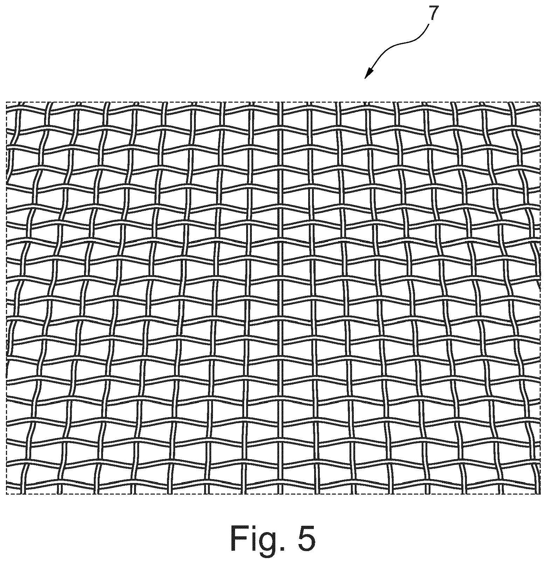

As mentioned hereinbefore, the insulatingly coated electrically conducting fibers 8 of the textile 7 may be woven, braided or knitted to each other or may be arranged parallel to each other. In this respect, Fig. 5 schematically shows a woven textile structure 7.

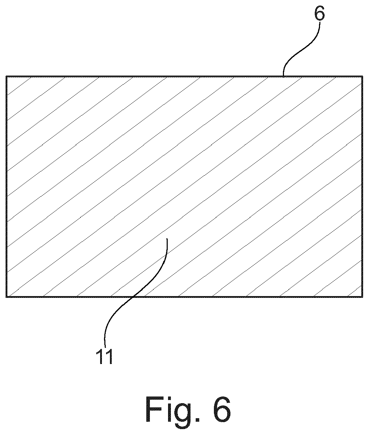

According to an embodiment of the invention as depicted in Fig. 6, the thermal radiation screen 6 comprises a metallic covering 11 for reducing emissivity, the metallic covering 11 comprising an aluminum tape and/or an aluminized polyester sheet.

Referring again to Fig. 1, the thermal radiation screen 6 comprises heat conducting terminals 12 for connecting to a cold head 13 of a cryostat 14 for the superconducting magnet coil 3.

In an embodiment the superconducting magnet coil 3 comprises high-temperature superconductor (HTS) material. If a magnet is built with an HTS superconductor, advantages in terms of thermal properties are provided, which can make the magnet more robust, i.e. more tolerant with respect to eddy currents. The higher temperature, at which the solenoid of the HTS superconductor is operated, greatly increases the cooling efficiency of the cryostat. For example, with a 4 K cryostat, the second stage may pump out magnitudes of 1 to 1.5 W, for a 18 K cryostat it is typically about 7 W. Due to the higher temperature, the heat capacity increases by a factor of more than 100, which means that energy input does not lead to quenching as easily as at 4 K. Therefore, it may be acceptable to have more gradient stray field in the magnet because the induction heat generated may be pumped away easily.

Accordingly, the superconducting magnet coils 3 may be formed with coils comprising HTS material, such as any of MgB₂, rare-earth barium copper oxide (ReBCO), bismuth strontium calcium copper oxide (BSCCO). The additional benefit is that such construction facilitates MR magnets to be quickly rampable (up or down). Such magnets can in principle be easily switched off when not in use, in order to minimize risks associated with the strong magnetic field. Examples of magnetic resonance imaging (MRI) systems with superconducting magnet comprising HTS material are for example presented in the European patent application 23197904 filed on September 18, 2023, and European patent application 24159684 filed on February 26, 2024, which are incorporated by reference herein in their entirety.

Alternatively or additionally, some or all of the superconducting magnet coils 3 may be made from regularly used materials niobium and titanium alloys (NbTi) or niobium and tin alloys (NbsSn).

It shall further be understood that one or more of the aforementioned embodiments of the invention may be combined as long as the combined embodiments are not mutually exclusive.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

## Claims

1. A magnet assembly (2) for use in a magnetic resonance examination system (1), comprising a superconducting magnet coil (3), a gradient coil system (4) with a plurality of gradient coils (5) for generating gradient fields, and a thermal radiation screen (6) which at least partly encloses the superconducting magnet coil (3), wherein the thermal radiation screen (6) is designed in such a way that its transmission rate for thermal radiation within a wavelength range from 780 nm to 2.5 µm is at least by a factor of 10 less than the transmission rate of radiation of the gradient fields.

2. The magnet assembly (2) according to claim 1, wherein the thermal radiation screen (6) comprises a textile structure (7) with electrically conducting fibers (8) which are each surrounded by an insulating coating (9).

3. The magnet assembly (2) according to claim 2, wherein the insulatingly coated electrically conducting fibers (8) of the textile (7) are woven, braided or knitted to each other or are arranged parallel to each other.

4. The magnet assembly (2) according to claim 2 or 3, wherein the electrically conducting fibers (8) of the textile structure (7) are metal filaments.

5. The magnet assembly (2) according to claim 4, wherein the electrically conducting fibers (8) of the textile structure (7) are Cu and/or Al filaments.

6. The magnet assembly (2) according to any one of claims 1 to 5, wherein the thermal radiation screen (6) comprises a supporting structure (10) to hold the textile structure (7) in place.

7. The magnet assembly (2) according to claim 6, wherein the supporting structure (10) is a backer structure which is separate from the textile structure (7).

8. The magnet assembly (2) according to claim 7, wherein the supporting structure (10) is made from an epoxy resin-glass fabric composite material.

9. The magnet assembly (2) according to claim 6, wherein the supporting structure (10) is integral with the textile structure (7).

10. The magnet assembly (2) according to claim 9, wherein the textile structure (7) is cast in resin.

11. The magnet assembly (2) according to any one of claims 1 to 10, wherein the thermal radiation screen (6) comprises a metallic covering (11) for reducing emissivity.

12. The magnet assembly (2) according to claim 11, wherein the metallic covering (11) comprises an aluminum tape and/or an aluminized polyester sheet.

13. The magnet assembly (2) according to any one of claims 1 to 12, wherein the thermal radiation screen (6) comprises heat conducting terminals (12) for connecting to a cold head (13) of a cryostat (14) for the superconducting magnet coil (3).

14. A magnetic resonance examination system (1) with a magnet assembly (2) according to any one of claims 1 to 13.

15. A method of use of a magnet assembly (2) according to any one of claims 1 to 13 for a magnetic resonance examination system (1).
